# EUROPEAN PATENT APPLICATION

(11) **EP 2 645 836 A1**
(43) Date of publication of application: **02.10.2013**
(21) Application number: 12290113.5
(22) Date of filing: 30.03.2012
(51) Int. Cl.: H05K 7/14, H05K 7/20

(54) **Mounting arrangement for orthogonally mounting plug-in cards**

(71) Applicant: Alcatel Lucent, 75007 Paris (FR)
(72) Inventor: Seitz, Reinhold Johannes, 91161 Hipoltstein (DE)
(74) Representative: Michalski Hüttermann & Partner Patentanwälte

(57) **Abstract**

The present invention relates to a mounting arrangement (1) for orthogonally mounting plug-in cards (14), comprising an enclosure (2) having a pair of opposite side walls (3), a top wall (4), and a bottom wall (5) forming a rectangular cross section, a midplane (10) with a midplane board (11) having at least one connection slot (40) on each of its opposite surfaces (12, 13) for connection of the plug-in cards (14), wherein the midplane board (11) is mounted within the enclosure (2) with an orientation orthogonally to the side walls (3), the top wall (4) and the bottom wall (5), and the at least one connection slot (40) on the one surface (12, 13) is or are arranged orthogonally to the at least one connection slot (40) on the other surface (12, 13), and two card cages (42) connected to the opposite surfaces (12, 13) of the midplane board (11) for receiving the plug-in cards (14), wherein the connection slots (40) and the card cages (42) are tilted compared to the walls (3, 4, 5).

## Description

The present invention relates to a mounting arrangement for orthogonally mounting plug-in cards.

Such mounting arrangements comprise an enclosure with a rectangular cross section, e.g. to be mounted in a rack. The mounting arrangement further comprises a midplane with a midplane board and an orthogonal connector system provided on the midplane board. The orthogonal connector system forms at least one connection slot on each of the opposite surfaces of the midplane board for receiving the plug-in cards. A card cage is provided at each surface of the midplane board for guiding and supporting the plug-in cards, and for providing electrical protection. The card cage may extend up to the height of plug-in cards connected thereto.

A plane defined by the midplane board is orientated orthogonally to side walls, a top wall and a bottom wall, thereby separating the enclosure into a front side and a rear side. The connection slots on the one surface are arranged in parallel to each other and orthogonally to the connection slots on the other surface, so that the plug-in cards on the front side and the rear side are arranged orthogonally to each other.

The slots in the enclosure have an orientation parallel to the walls, i.e. the slots on one surface of the midplane have an orientation in parallel to the side walls and the slots on the other surface have an orientation in parallel to the top wall and the bottom wall. Accordingly, plug-in cards connected to one surface of the midplane are arranged in a horizontal direction, supposing that the enclosure is mounted in a horizontal or vertical direction, which makes cooling complicated and requires the provisioning of cooling means, since normal convection will not occur. The design of the mounting arrangement is also different in respect to the opposite surfaces of the midplane, so that different components have to be used in the front side and the rear side of the enclosure, or the components have to be mounted differently. Also cabling, either for power supply or data cabling has to be provided individually for both sides. Extra components have to be considered right from the beginning when planning the mounting arrangement, since the arrangement of the slots is usually made without spare mounting space. Accordingly, the orthogonal card orientation causes a fairly complex design of the mounting arrangement, especially with respect to thermal management.

Such mounting arrangements are for example used in the telecom industry for the definition of high-end optical cross-connect systems up to 20Tb/s switching capacity and beyond. For such high-end applications it is important to provide solutions that are technically feasible and cost competitive. Also the design of the midplane itself has to be optimized in terms of reduction of trace lengths for high speed signals with signal speeds up to 25 GB/s.

It is therefore an object of the present invention to provide a mounting arrangement that can be flexibly used, that enables an improved and simple cooling for plug-in cards, that enables an improved and simple connection of plug-in cards, that is suitable for high performance applications, and that is easy to manufacture.

This object is achieved by the independent claim. Advantageous embodiments are given in the dependent claims.

In particular, the present invention provides a mounting arrangement for orthogonally mounting plug-in cards, comprising an enclosure having a pair of opposite side walls, a top wall, and a bottom wall forming a rectangular cross section, a midplane with a midplane board having at least one connection slot on each of its opposite surfaces for connection of the plug-in cards, wherein the midplane board is mounted within the enclosure with an orientation orthogonally to the side walls, the top wall and the bottom wall, and the at least one connection slot on the one surface is or are arranged orthogonally to the at least one connection slot on the other surface, and two card cages connected to the opposite surfaces of the midplane board for receiving the plug-in cards wherein the connection slots and the card cages are tilted compared to the walls.

The basic idea is to provide the slots and the card cage with an orientation, which is not parallel to the walls of the enclosure. Since the enclosure is mounted in a horizontal or vertical orientation, the orientation of the plug-in cards is not horizontal, so that no horizontal airflow is necessary for cooling purposes, which facilitates thermal management. By tilting the card cage the complete arrangement allows a vertical airflow at the front and rear side. The arrangement creates a fairly large plenum at the bottom at top side of the card cage and in front of the plenum there is plenty of space available for proper cable management. Natural convection from bottom to top, i.e. in the vertical direction, supports cooling. Accordingly, an air flow direction from bottom to top, which is a common solution in many existing applications, especially in high-end applications, can easily be applied. Preferably, the air flow is supported by the card cage, e.g. by guiding the air flow along the plug-in cards. Furthermore, a symmetric design approach in respect to a front side and a rear side of the mounting arrangement can be applied despite of the orthogonal card orientation of the midplane. Accordingly, harmonized thermal management and cable management for front and rear side with same design principles can be applied. Also the midplane can be designed symmetrically in respect to both surfaces. Accordingly, the same concept for power distribution on the midplane can be easily applied. The tilt angle can be freely chosen, depending on floor planning of plug-in cards to be connected to both surfaces of the midplane. Depending on the tilt angle, free spaces with a triangular shape are generated within the enclosure above and beneath the plug-in cards. This facilitates separate cable management for front and rear side with easy separation of power wires, electrical and optical cabling. Accordingly, the enclosure is capable for high cable volumes due to the triangular spaces above and beneath the plug-in cards, without the need for extra height allocation. Separate power paths, e.g. in the form of redundant power supplies, and redundant fans for cooling the plug-in cards can easily be provided. Preferably, the enclosure has two opposite openings at its front and rear side, which can be used for accessing the interior of the enclosure. In particular, the plug-in cards can be inserted into and removed from the midplane, and plug-in cards can be connected, i.e. to a power supply or a data cable, via the openings at the front and rear side. Further preferred, the opposite surfaces of the midplane face the openings to facilitate the access. The midplane interconnects the plug-in cards of the two surfaces with each other. It can provide direct card interconnection from front to rear via the midplane without any traces on the midplane itself. The midplane can further perform any kind of intermediate processing of signals provided from the plug-in cards of the one surface to the plug-in cards of the other surface. The midplane is usually positioned in the middle of the enclosure between its front side and its rear side. Nevertheless, the location within the enclosure can vary, e.g. depending on the size of plug-in cards connected to the opposite surfaces or due to other requirements, e.g. for power supply of data connections. The midplane board has the slots mounted thereon. The slots are preferably formed by multiple orthogonal connectors, to which the plug-in cards are connected. Accordingly, it is to be noted that a slot is defined according to the direction of a plug-in card to be connected, even when the slot is formed by multiple single connectors, which are provided to connect one or multiple plug-in cards in parallel to each other. The orthogonal arrangement of the plug-in cards refers to an arrangement of the plug-in cards on each surface of the midplane in parallel to each other, wherein the plug-in cards on the one surface have an orientation orthogonal to the plug-in cards of the other surface. Accordingly, a minimum of two slots is provided on the two surfaces of the midplane. Usually, each surface is provided with multiple slots. It is further to be noted that the slots can be of any kind suitable for electrically, optically and mechanically connecting the plug-in cards. The midplane can be of any size, e.g. fully separating the enclosure into a front part and a rear part, or provide only a partial separation between the front part and the rear part. Preferably, the midplane board is used to distribute power to plug-in cards connected thereto. The card cages are mounted on both surfaces of the midplane board for guiding and supporting the plug-in cards, and for providing electrical protection.

According to a preferred embodiment the connection slots and the card cages are tilted with an angle of 40 to 50 degrees, preferably with an angle of approximately 45 degrees. This tilt angle enables heat dissipation for plug-in cards connected to both surfaces of the midplane in a similar way, since a vertical airflow is possible for both the front and the rear side along the plug-in cards. No cards are oriented horizontally on the midplane. Also cable management can be done in the same manner on the front as well as on the rear side. It provides an at least almost symmetric orientation of the plug-in cards within the enclosure when looking from the front or the rear side thereof, which facilitates the design of the mounting arrangement. Space for cabling, ventilation and/or extra components is generated at all sides of the card cage in respect to the plane of the midplane board on both surfaces thereof.

According to a preferred embodiment the midplane is adapted to connect plug-in cards generating a different amount of heat in operation, and the connection slots and the card cage of the surface to be connected to the plug-in cards producing the bigger amount of heat are positioned with a tilt angle of less than 45 degrees in respect to the side walls. The side walls are supposed to have a vertical orientation so that plug-in cards generating more heat have a more vertical orientation than those generating less heat. Accordingly, natural convection from bottom to top supports cooling of the plug-in cards positioned with a tilt angle of less than 45 degrees in respect to the side walls, and no horizontal airflow has to be provided. According to a preferred embodiment the enclosure is adapted to be mounted in a rack. Rack mounting facilitates the use of multiple mounting arrangements to interconnect an increased number of plug-in cards, as required for example in telecom applications. Due to the conventional outer design of the mounting arrangement, the mounting arrangement can be used together with conventional sub-rack designs, e.g. to enable an individual substitution of mounting arrangements. Easy cable management for plug-in cards on both surfaces of the midplane with direct access to vertical cable duct of the rack can be realized. Available racks do not have to be substituted when exchanging mounting arrangements. Preferably, the enclosure is provided with a geometry as defined by ETSI/IEC/ANSI/EIA standard to fit in commonly available racks, which are widely available.

According to a preferred embodiment the mounting arrangement comprises at least one power supply unit and/or at least one fan unit, which are mounted on the midplane. Hence, the power supply unit and/or the fan unit are easily mountable within the enclosure, e.g. by means of a plug-connection on the midplane, in particular on the midplane board. In case of failure, the power supply unit and/or the fan unit can easily be replaced. The power supply unit refers to a unit used for providing power to the plug-in cards, either directly or via the midplane, and the fan unit refers to a unit for providing an air-flow along the plug-in cards for cooling. The orientation within the mounting arrangement is preferably that each power supply unit and each fan unit provides power or cooling, respectively, to plug-in cards connected on the same surface of the midplane. Different power supply units and/or fan units can be provided depending on requirements of the plug-in cards to be connected to the respective surfaces of the midplane. In an alternative embodiment, all power supply units and fan units are of the same type, respectively. The design of the enclosure can be simple and without means for mounting power supply and/or fan units, in particular when all power supply and/or fan units are directly connected to the midplane. Further preferred, power supply and/or fan units are provided redundantly to increase system stability and reliability. Still further preferred, redundant power supply units are employed to independently power redundant fan units.

According to a preferred embodiment the at least one power supply unit and/or the at least one fan unit are mounted in the vertical axis above and/or below the at least one connection slot and the card cage. In case of the fan units, this arrangement facilitates cooling based on natural convection from bottom to top. Also, common solutions having a conventional air flow direction from bottom to top, e.g. like used in existing high-end applications, can easily be supported. Space next to the fan unit can easily be used for the power supply unit, so that fan units and power supply unit are mounted side-by-side. The width of the mounting arrangement is not increased due to the presence of the units.

According to a preferred embodiment the at least one power supply unit and/or the at least one fan unit are provided as individual modules. The modular design facilitates provisioning of mounting arrangements for different applications within the same enclosure. Also a modification of the mounting arrangement is easily possible at any time. The modules can be provided depending on requirements of the plug-in cards to be connected to the respective surface of the midplane. In an alternative embodiment, all power and fan modules are of the same type. The fan units and the power supply units are preferably provided as push-pull units. Further preferred, the units are identical in respect to the opposite sides of the midplane. The concept for power supply with multiple modules further allows a breakdown of amperage to customer needs (e.g. 50A max.). In case further power or cooling is required, a further module can be used to provide this. Preferably, power supply units and/or fan units are horizontally and vertically positioned within the enclosure in a diametric manner, according to the tilt of the card cage.

According to a preferred embodiment the mounting arrangement comprises at least two fan units arranged at one surface of the midplane), wherein one fan unit is located in a space below the at least one connection slot and the other fan unit is located in a space above the at least one connection slot, and the fan units are arranged to form an push-pull air flow from the fan unit located in the space below the at least one connection slot to a lower axial end of the connection slot, along the connection slot to an upper axial end thereof, and from the upper axial end to the fan unit located in the space above the at least one connection slot. The design of the mounting arrangement can be that one of the fan units is redundant. With a number of four fan units, efficient cooling can be provided for plug-in-cards on both surfaces of the midplane. Further preferred, airflow areas are closed to the front side so that these areas form a channel for the airflow and cable management can be provided above and below the plug-in-cards within the card cage in the mounting arrangement. In a modified embodiment, instead of a push-pull arrangement of fan units above and below the card cage, only one fan unit is provided above or below the card cage to provide a pull-only or push-only, respectively, on the respective surface of the midplane board.

According to a preferred embodiment the at least one power supply unit is located in a space laterally to the card cage in accordance with a lateral direction of the at least one connection slot of one surface of the midplane at the respective surface thereof. This arrangement enables good natural convection towards the plug-in cards, along the plug-in cards, and away from the plug-in cards, since the at least one power supply unit is out of the path of the natural convection. Due to the proximity to the midplane or the plug-in cards and the card cage, cabling can be made simple and short.

According to a preferred embodiment the design of the mounting arrangement is identical on both sides of the midplane when facing the respective surfaces of the midplane. Accordingly, not only the design principles are identical, but also the particular design of the mounting arrangement, including architecture for front and rear side of the mounting arrangement, harmonized thermal management, and harmonized power architecture. Also power distribution on the midplane follows the same concept for both opposite surfaces. Mounting of plug-in cards, power supply units, fan units as well as cabling and connection of the midplane and the plug-in cards can be performed identically, independent to which surface of the midplane it refers.

According to a preferred embodiment the shape of the midplane corresponds to an area covered by the card cages on both surfaces thereof and is essentially limited to this shape. Preferably, remaining areas are filled with mechanical structures to map with the enclosure. The midplane is mounted within the enclosure by any kind of suitable means. The reduction of the size of the midplane reduces the costs thereof. Preferably, cables are used for power supply to the midplane and the fan unit. Also traces on the midplane can be limited to a minimum size, thereby enabling high data throughput. Further preferred, direct card interconnection between the front side and the rear side can be provided without any traces on the midplane, e.g. by use of orthogonal connectors. Furthermore, the midplane provides only a partial separation of the front part and the rear part of the enclosure, thereby enabling simple mounting of components and easy cabling. Cooling, especially of extension cards, can be applied between the opposite sides of the midplane via spaces extending horizontally between the midplane and the card cages and walls of the enclosure, e.g. for circulating air horizontally between the front side and the rear side of the enclosure.

According to a preferred embodiment the mounting arrangement comprises a direct card interconnection for connecting plug-in cards of opposite surfaces of the midplane. Accordingly, the plug-in card of opposite surfaces of the midplane can be connected without traces via an orthogonal connector system on the midplane board. Traces on the midplane can be limited to a minimum, with short trace lengths between the connected plug-in cards, thereby enabling high data throughput.

According to a preferred embodiment the mounting arrangement comprises power cables for connection to the plug-in cards, wherein the power cables are provided to connect the plug-in cards from a direction laterally to the at least one connection slot and the respective sides of the card cage. This allows providing power to the plug-in cards without interfering with airflow in direction parallel to the plug-in cards, either due to normal convection or supported by at least one fan unit. The plug-in cards can be connected to the power cables from the front side or the rear side of the enclosure, respectively. Each space laterally to the plug-in cards, i.e. each direction laterally to card cages in accordance with a lateral side of the connection slots, can be used independently for providing the power cables and connecting them to the plug-in cards. Accordingly, power cables can be easily separated from other cables, e.g. data cables provided within the enclosure. Accordingly, high numbers of power cables can be provided due to sufficient space above and beneath the plug-in cards. No extra height allocation is required for power cable management. Furthermore, the opposite spaces can be easily used for providing separate power paths, e.g. redundant A and B feeds.

According to a preferred embodiment the mounting arrangement comprises data cables for connection to the plug-in cards, wherein one end of the data cables is provided to connect the plug-in cards from the side of the axial ends of the at least one connection slot. Date cables refer to any kind of wiring suitable for electric and/or optical data transmission. Preferably, the data cables are optical fibers. Such data cables usually have a small diameter and do not obstruct airflow to or away from the card cage containing the plug-in cards, either due to normal convection or supported by at least one fan unit. Preferably, the data cables are routed between a closed airflow area and the front side or the rear side, so that they are positioned out of the airflow to and away from the card cage containing the plug-in cards. Further preferred, the plug-in cards are connected to the data cables from their longitudinal ends. Each space in front of the plug-in cards as well at the axial or longitudinal ends of the connection slots or plug-in cards can be used independently for providing the data cables and connecting them to the plug-in cards. Accordingly, data cables can be easily separated from other cables, e.g. power cables, which are provided within the enclosure. Accordingly, high numbers of data cables can be provided due to sufficient space at the axial ends of the plug-in cards. No extra height allocation is required for data cable management.

According to a preferred embodiment the enclosure has a depth providing space between the card cages and its front side and its rear side, respectively. This space is suitable for cable management, cooling or extensions.

According to a preferred embodiment the midplane comprises at least one extension slot for connecting extension devices, wherein the at least one extension slot is located in a direction laterally to the at least one connection slot of the midplane. The extension slots are preferably used for extension devices like controllers, service devices, maintenance devices, timing devices or others. Preferably, the extension devices refer to the operation of the midplane itself. Positioning and orientation of the extension slots can be freely chosen within the mounting arrangement, e.g. depending on thermal requirements.

Some embodiments of apparatus in accordance with the present invention are now described, by way of example only, and with reference to the accompanying drawings, in which:
- Fig. 1: is a schematic sectional view from the front of a mounting arrangement according to a first embodiment at its front side,
- Fig. 2: is a schematic sectional view from the rear of a mounting arrangement according to a first embodiment at its rear side,
- Fig. 3: is a schematic top view of the mounting arrangement according to Fig. 1,
- Fig. 4: is a schematic perspective view of the mounting arrangement according to Fig. 1 illustrating natural thermal convection within the mounting arrangement,
- Fig. 5: is a schematic perspective view of the mounting arrangement according to Fig. 1 illustrating data cabling of the mounting arrangement,
- Fig. 6: is a schematic perspective view of the mounting arrangement according to a second embodiment with power routing via the midplane to the plug-in cards,
- Fig. 7: is a schematic perspective view of a mounting arrangement according to a third embodiment with additional extension cards connected to the midplane illustrating natural thermal convection within the mounting arrangement,
- Fig. 8: is a schematic perspective view of a mounting arrangement according to a fourth embodiment with a midplane having a shape corresponding to an area covered by its connection slots, and
- Fig. 9: is a schematic frontal view of a midplane according to the fourth embodiment.

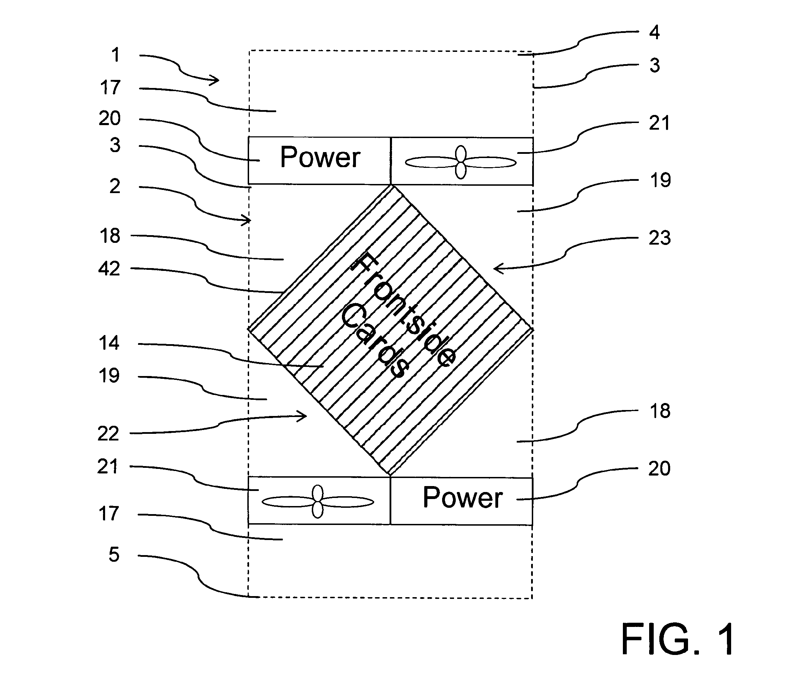

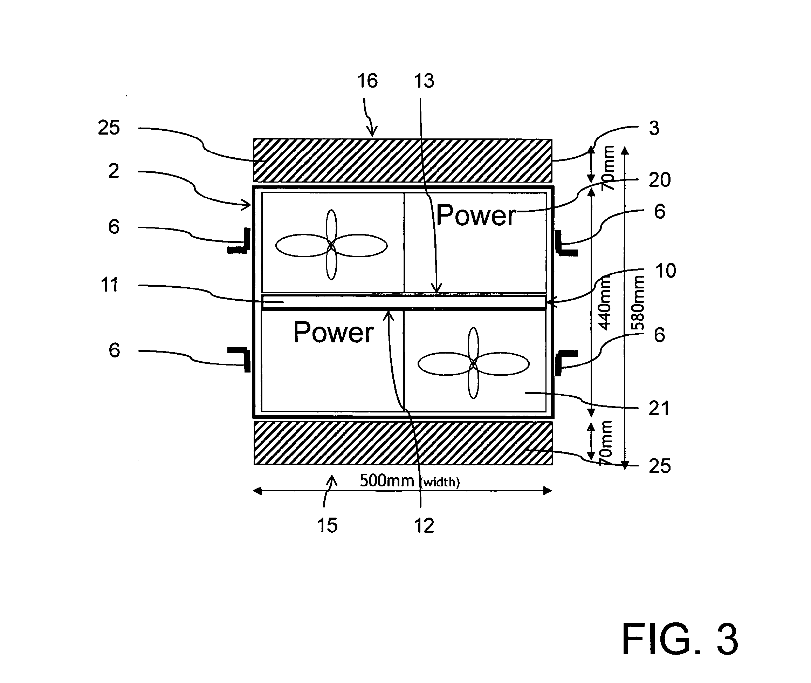

Figures 1 to 5 show a mounting arrangement 1 according to a first embodiment. The mounting arrangement 1 comprises an enclosure 2 having a pair of opposite side walls 3, a top wall 4, and a bottom wall 5 forming a rectangular cross section of the enclosure 2. The enclosure 2 is adapted to be mounted in a rack, as can be seen in Fig. 3. Accordingly, the enclosure 2 is provided with a set of mounting brackets 6 for mounting in the rack. In particular, the enclosure 2 is provided with a geometry as defined by ETSI/IEC/ANSI/EIA standard to fit in commonly available racks. The measures given in Fig. 3 are merely given by way of example without limiting the mounting arrangement 1 to these measures.

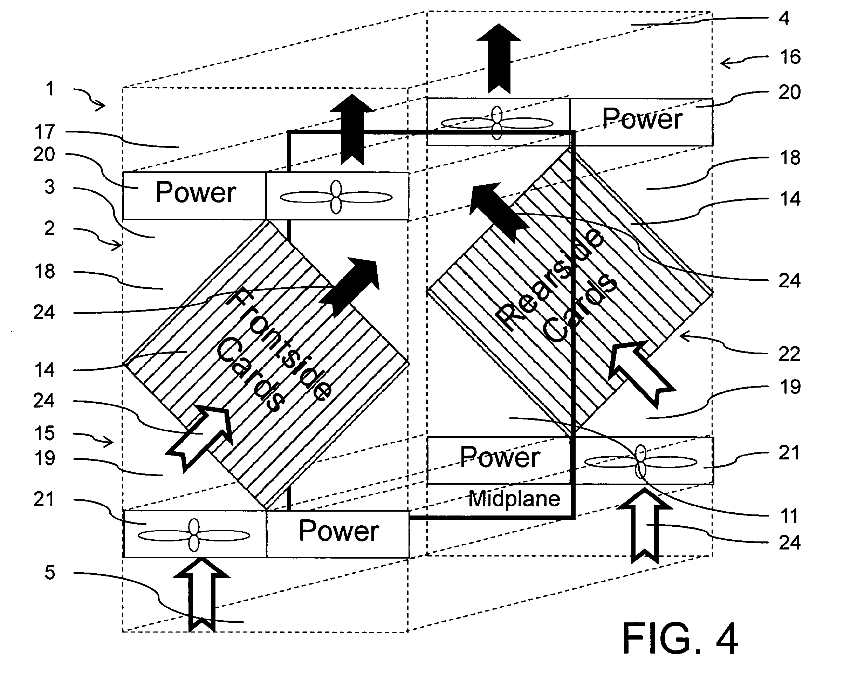

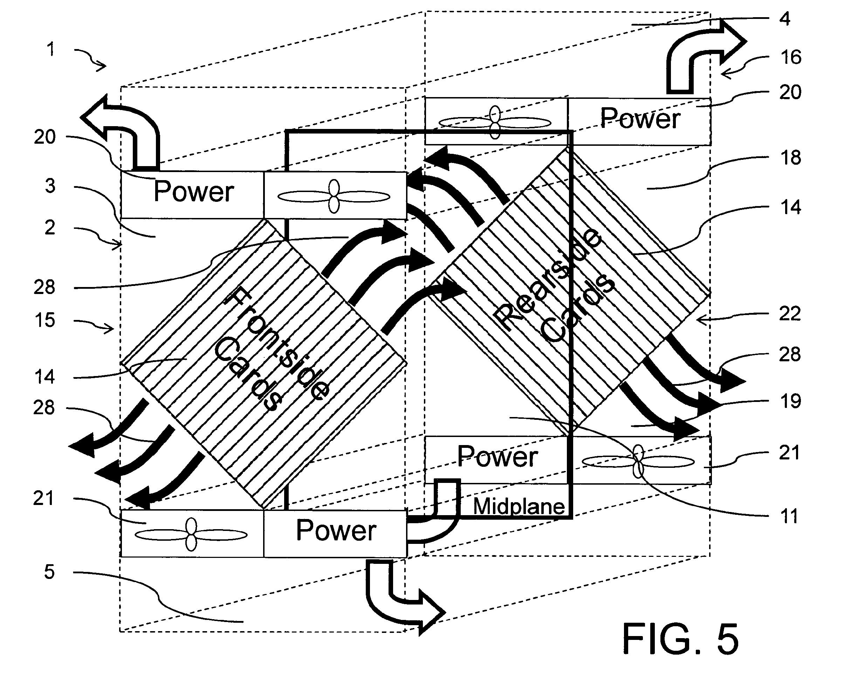

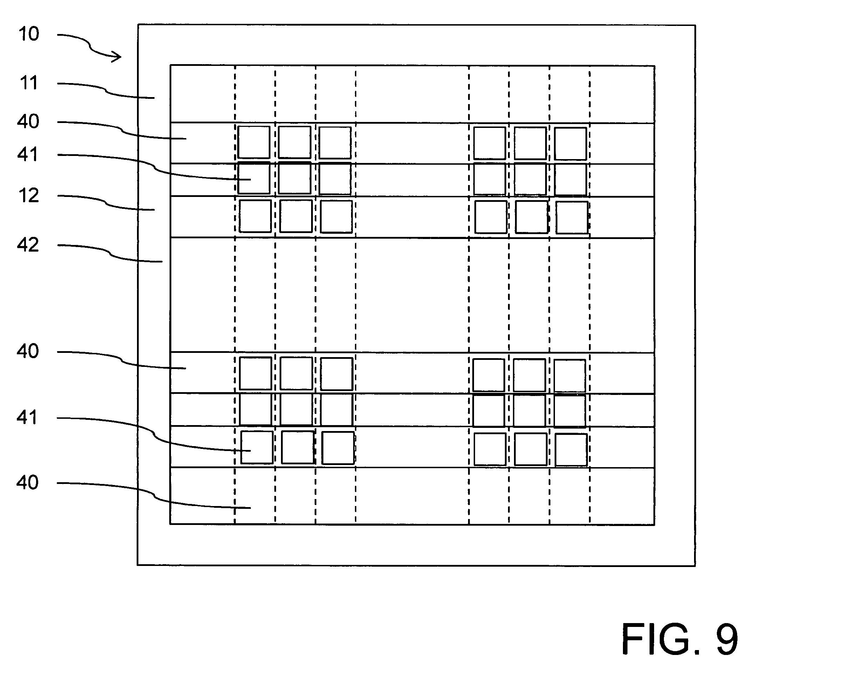

The mounting arrangement 1 further comprises a midplane 10, which comprises a midplane board 11 and multiple connection slots 40, as can be seen with respect to Fig. 9. The connection slots 40 are formed by a set of orthogonal connectors 41, which are mounted on the midplane board 11 for receiving plug-in cards 14. In this embodiment, a slot 40 is defined by orthogonal connectors 41, which are commonly connected by one plug-in card 14 and according to the orientation of the connected plug-in card 14. The slots 40 on the one surface 12 are arranged orthogonally to the slots 40 of the other surface 13 of the midplane board 11, as indicated in Fig. 9 by the slots 40 shown with continuous lines or dashed lines and which is also applicable for the mounting arrangement 1 of the first embodiment. The orthogonal connectors 41 of the midplane 10 interconnect the plug-in cards 14 of the opposite surfaces 12, 13 of the midplane 10 with each other, as indicated for example in Figures 4 and 5. Furthermore, a card cage 42 is mounted on each surface 12, 13 for guiding and supporting the plug-in cards 14, and for providing electrical protection.

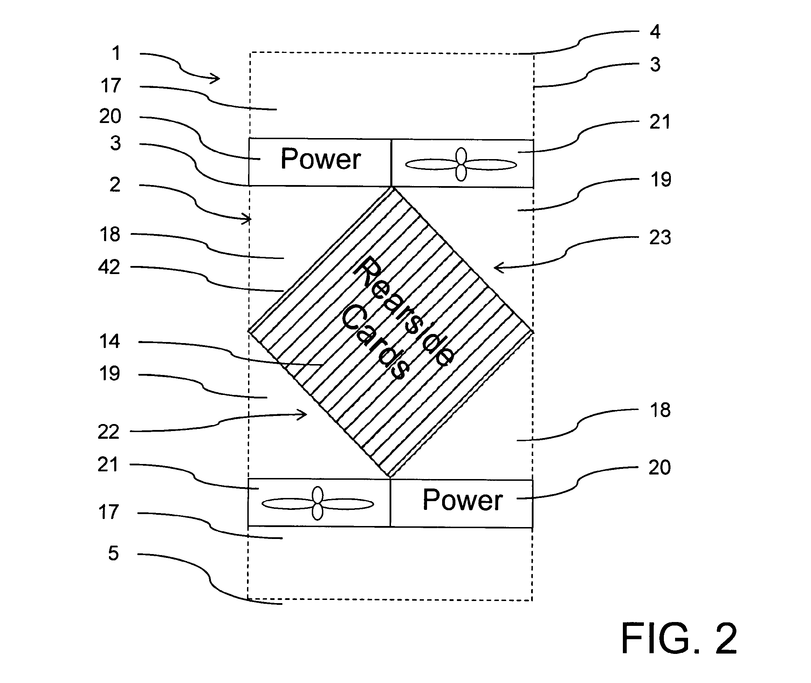

A plane defined by the midplane 10, i.e. the plane of its midplane board 11, is orientated orthogonally to the side walls 3, the top wall 4 and the bottom wall 5. The connection slots 40 and the card cages 42 are tilted compared to the walls 3, 4, 5 with an angle of approximately 45 degrees. Accordingly, when facing the mounting arrangement 1 from its front side 15 or its rear side 16, the orientation of the connection slots 40, the plug-in cards 14 and the card cage 42 is identical, as can be seen in Figures 1 and 2. In other embodiments the tilt angle differs from 45 degrees. In a further different embodiment the midplane 10 is adapted to connect plug-in cards 14 generating a different amount of heat in operation, and the connection slots 40 and the card cage 42 of the surface 12, 13 to be connected to the plug-in cards 14 producing the bigger amount of heat are positioned with a tilt angle of less than 45 degrees in respect to the side walls 3.

The midplane 10 of this embodiment is positioned approximately in the middle of the enclosure 2 between its front side 15 and its rear side 16. In other embodiments, the location of the midplane 10 is shifted away from the middle of the enclosure 2, either to its front side 15 or to its rear side 16.

The midplane 10 in this embodiment, in particular the midplane board 11 has a rectangular shape and extends horizontally between both side walls 3. In the vertical direction, it does not extend up to the top wall 4 and down to the bottom wall 5, thereby leaving spaces 17 between the midplane board 11 and the respective wall 4, 5, in which a horizontal airflow between the front side 15 and the rear side 16 is established in this embodiment.

Four free spaces 18, 19 with a triangular shape are provided within the enclosure 2 above and beneath the card cage 42 with the plug-in cards 14 on both sides of the midplane board 11, suitable for connection purposes as explained further below. Free spaces 19 are provided at axial ends of the slots 40 and free spaces 18 are provided laterally to the connection slots 40 and the card cage 42.

The mounting arrangement 1 further comprises a total of four power supply units 20 and four fan units 21, which are mounted on the midplane 10. The power supply units 20 and the fan units 21 are provided as identical modules for mounting by means of a plug-connection, two of each connected to each surface 12, 13 of the midplane board 11. The power supply units 20 are located laterally to the card cage 42 in accordance with a lateral direction of the slots 40 and provide power to the plug-in cards 14 connected to the respective surface 12, 13 of the midplane 10 via the midplane board 11 and the connection slots 40. Power distribution on the midplane board 11 follows the concept of identical design for both opposite surfaces 12, 13. The power supply units 20 provide redundant power to the plug-in cards 14.

The fan units 21 are provided as push-pull units with two fan units 21 arranged at each surface 12, 13 of the midplane 10. One fan unit 21 is located above and the other below the connection slots 40 and the card cage 42. The fan units 21 are arranged to form a push-pull air flow to a lower end 22 of the connection slots 40, along the connection slots 40 and away from an the upper end 23 of the connection slots 40, as indicated by arrows 24. Thereby, the fan units 21 are provided with a push-pull arrangement. The two power supply units 20 provide redundant power to the fan units 21 via the midplane board 11. The card cage 42 provides additional guidance of the airflow along the plug-in cards 14. In this embodiment, the midplane board 11, the card cage 42 and the free spaces 19, which are closed at their front sides, form a closed air channel, and air is pushed/pulled through this air channel by the fan units 21.

Instead of a push-pull arrangement of the fan units 21, in an alternative embodiment only one fan unit 21 is provided to implement a push-only or pull-only air-flow.

The power supply units 20 and the fan units 21 are mounted in the vertical axis above and below the connection slots, as can be seen in figures 1 to 5. As further indicated in Fig. 3, the enclosure 2 has a depth bigger than the depth of the plug-in cards 14 and the card cages 42, as shown in Fig. 3 covered by the power supply units 20 and the fan units 21, together with the midplane board 11, thereby leaving spaces 25 between the plug-in cards 14 connected thereto with the respective card cage 42 and its front side 15 and its rear side 16, respectively.

Instead of providing power units 20 above and below the connection slots 40 and the respective card cage 42, in alternative embodiments power units 20 are only provided above or below the connection slots 40 and the respective card cage 42 within the enclosure 2.

The plug-in-cards 14 of the mounting arrangement 1 are connected to data cables, as indicated by arrows 28 in Fig. 5, for connection to the plug-in cards 14, wherein one end of the data cables 28 is provided to connect the plug-in cards 14 from the sides of the axial ends 22, 23 of the connection slots 40. The data cables 28 pass in front of the air channels. The data cables 28 according to this embodiment are optical fibers. In alternative embodiments, the data cables 28 are electric wires.

Overall, the design of the mounting arrangement 1 is identical on both sides of the midplane 10 when facing the respective surfaces 12, 13 thereof, as can be seen in Figures 1 and 2, which show different views of the mounting arrangement 1, but which are essentially identical.

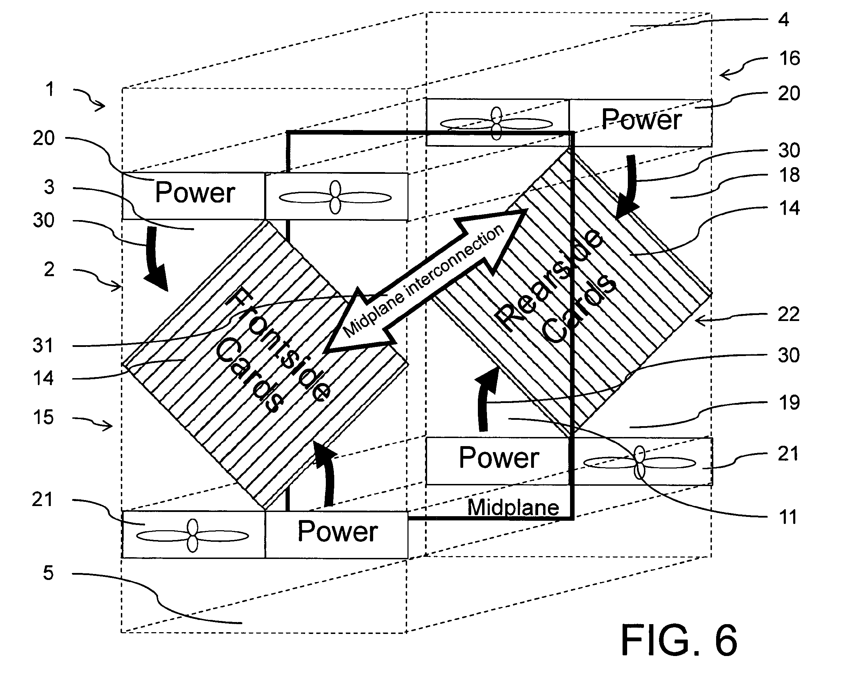

According to a second embodiment of the mounting arrangement 1, which is shown in Fig. 6 and which is essentially identical to the mounting arrangement 1 of the first embodiment, the power supply units 20 are connected to the plug-in cards 14 by means of power cables 30 and via the midplane board 11. The power cables 30 are provided to connect the midplane board 11 from a direction laterally to the connection slots 40. The power cables 30 extend from the free space 18 over the card cage 42. The power supply units 20 of each surface 12, 13 of the midplane board 11 provide separate, redundant power paths, e.g. referred to as A and B feeds.

Furthermore, a direct card interconnection 31 between the front side 15 and the rear side 16 of the enclosure 2 is provided without traces on the midplane board 11, as already explained for the mounting arrangement 1 of the first embodiment with respect to Fig. 9. The direct card interconnection 31 connects with its orthogonal connectors 41 plug-in cards 14 of opposite surfaces 12, 13 of the midplane board 11.

Further details of the mounting arrangement 1 of the second embodiment are identical to those of the mounting arrangement 1 of the first embodiment.

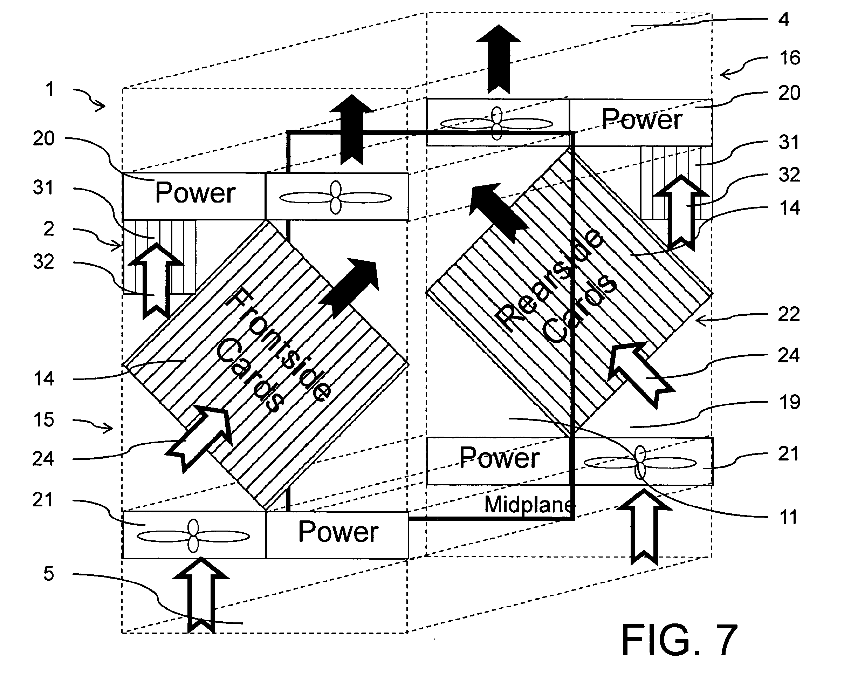

According to a third embodiment, which is shown in Fig. 7, the mounting arrangement 1 is provided with extension cards 35, which are connected to extension slots of the midplane 10. The extension slots, which are not explicitly shown in Fig. 7, are located in a direction laterally to the connection slots 40, the plug-in cards 14, and the card cage 42, and are connected to the midplane 10. The extension cards 35 refer to extension devices like controllers, service devices, maintenance devices, timing devices and others. Cooling of the extension cards 35 is applied by natural thermal convection, as indicated in Fig. 7 by arrows 32.

Apart from these differences, the mounting arrangement 1 of the third embodiment is identical to the mounting arrangement 1 of the first embodiment.

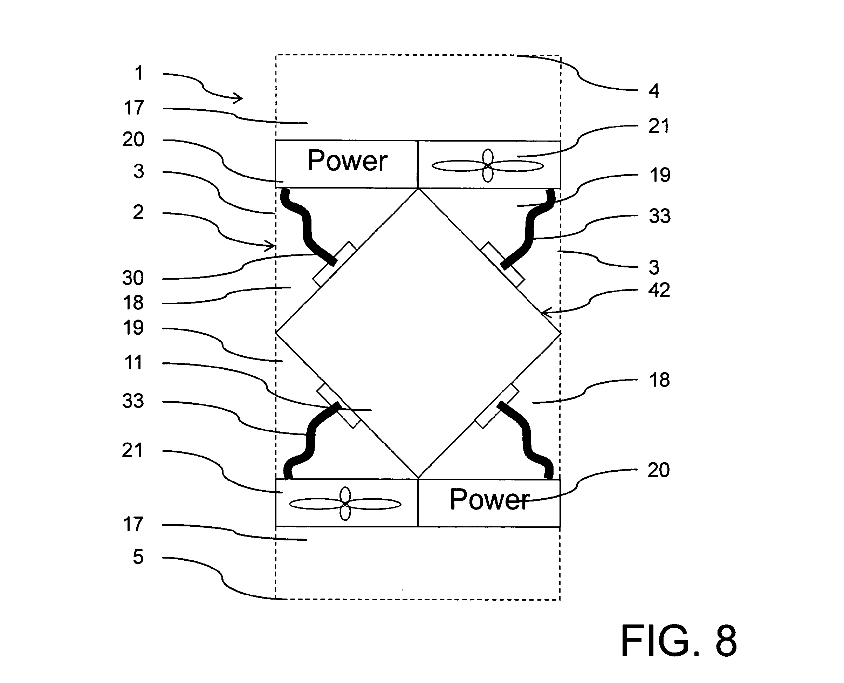

According to a fourth embodiment of the mounting arrangement 1, which is shown in Figures 8 an 9, the shape of the midplane 10 corresponds to an area covered by the connection slots 40 and the card cages 42 of both surfaces 12, 13 of the midplane 10 and is essentially limited to this shape, as seen in Fig. 9.

Accordingly, power cables 30 are used for direct power supply to the midplane 10. The fan units 21 are also powered by the power supply units 20 via the midplane 10 and extra power cables 33, which are also shown in Fig. 8.

Apart from these differences, the mounting arrangement 1 of the fourth embodiment is identical to the mounting arrangement 1 of the first embodiment.

The present inventions may be embodied in other specific apparatus. The described embodiments are to be considered in all respects as only illustrative and not restrictive. In particular, the scope of the invention is indicated by the appended claims rather than by the description and figures herein. All changes that come within the meaning and range of equivalency of the claims are to be embraced within their scope.

## Claims

1. A mounting arrangement (1) for orthogonally mounting plug-in cards (14), comprising
an enclosure (2) having a pair of opposite side walls (3), a top wall (4), and a bottom wall (5) forming a rectangular cross section,
a midplane (10) with a midplane board (11) having at least one connection slot (40) on each of its opposite surfaces (12, 13) for connection of the plug-in cards (14), wherein the midplane board (11) is mounted within the enclosure (2) with an orientation orthogonally to the side walls (3), the top wall (4) and the bottom wall (5), and the at least one connection slot (40) on the one surface (12, 13) is or are arranged orthogonally to the at least one connection slot (40) on the other surface (12, 13), and
two card cages (42) connected to the opposite surfaces (12, 13) of the midplane board (11) for receiving the plug-in cards (14),
wherein
the connection slots (40) and the card cages (42) are tilted compared to the walls (3, 4, 5).

2. The mounting arrangement (1) according to claim 1,
**characterized in that**
the connection slots (40) and the card cages (42) are tilted with an angle of 40 to 50 degrees, preferably with an angle of approximately 45 degrees.

3. The mounting arrangement (1) according to claim 1,
**characterized in that**
the midplane (10) is adapted to connect plug-in cards (14) generating a different amount of heat in operation,
and
the connection slots (40) and the card cage (42) of the surface (12, 13) to be connected to the plug-in cards (14) producing the bigger amount of heat are positioned with a tilt angle of less than 45 degrees in respect to the side walls (3).

4. The mounting arrangement (1) according to claim 1,
**characterized in that**
the enclosure (2) is adapted to be mounted in a rack.

5. The mounting arrangement (1) according to claim 1,
**characterized in that**
the mounting arrangement (1) comprises at least one power supply unit (20) and/or at least one fan unit (21), which are mounted on the midplane (10).

6. The mounting arrangement (1) according to claim 5,
**characterized in that**
the at least one power supply unit (10) and/or the at least one fan unit (21) are mounted in the vertical axis above and/or below the at least one connection slot (40) and the card cage (42).

7. The mounting arrangement (1) according to claim 6,
**characterized in that**
the at least one power supply unit (20) and/or the at least one fan unit (21) are provided as individual modules.

8. The mounting arrangement (1) according to any preceding claim in combination with claim 6,
**characterized in that**
the mounting arrangement (1) comprises at least two fan units (21) arranged at one surface (12, 13) of the midplane (10), wherein
one fan unit (21) is located in a space below the at least one connection slot (40) and the other fan unit (21) is located in a space above the at least one connection slot (40), and
the fan units (21) are arranged to form an push-pull air flow (24) from the fan unit (21) located in the space below the at least one connection slot to a lower axial end (22) of the connection slot (40), along the connection slot (40) to an upper axial end (23) thereof, and from the upper axial end (23) to the fan unit (21) located in the space above the at least one connection slot (40).

9. The mounting arrangement (1) according to claim 1,
**characterized in that**
the at least one power supply (20) unit is located in a space laterally to the card cage (42) in accordance with a lateral direction of the at least one connection slot (40) of one surface (12, 13) of the midplane (10) at the respective surface (12, 13) thereof.

10. The mounting arrangement (1) according to claim 1,
**characterized in that**
the design of the mounting arrangement (1) is identical on both sides of the midplane (10) when facing the respective surfaces (12, 13) of the midplane (10).

11. The mounting arrangement (1) according to claim 1,
**characterized in that**
the shape of the midplane (10) corresponds to an area covered by the card cages (42) on both surfaces (12, 13) thereof and is essentially limited to this shape.

12. The mounting arrangement (1) according to claim 1,
**characterized in that**
the mounting arrangement (1) comprises a direct card interconnection (31) for connecting plug-in cards (14) of opposite surfaces (12, 13) of the midplane (10).

13. The mounting arrangement (1) according to claim 1,
**characterized in that**
the mounting arrangement (1) comprises power cables (30) for connection to the plug-in cards (14), wherein the power cables (30) are provided to connect the plug-in cards (14) from a direction laterally to the at least one connection slot (40) and the respective sides of the card cage (42).

14. The mounting arrangement (1) according to claim 1,
**characterized in that**
the mounting arrangement (1) comprises data cables (28) for connection to the plug-in cards (14), wherein one end of the data cables (28) is provided to connect the plug-in cards (14) from the side of the axial ends (22, 23) of the at least one connection slot (40).

15. The mounting arrangement (1) according to claim 1,
**characterized in that**
the midplane (10) comprises at least one extension slot for connecting extension devices (35), wherein the at least one extension slot is located in a direction laterally to the at least one connection slot (40) of the midplane (10).
